# EUROPEAN PATENT APPLICATION

(11) **EP 3 787 053 A1**
(43) Date of publication of application: **03.03.2021**
(21) Application number: 19742116.7
(22) Date of filing: 07.01.2019
(51) Int. Cl.: H01L 51/52, H01L 51/56, H01L 27/32

(54) **ORGANIC LIGHT-EMITTING TRANSISTOR AND MANUFACTURING METHOD THEREFOR, DISPLAY PANEL, AND ELECTRONIC DEVICE**

(30) Priority: 26.04.2018 CN 201810388274
(71) Applicant: BOE TECHNOLOGY GROUP CO., LTD., Beijing 100015 (CN)
(72) Inventor: The designation of the inventor has not yet been filed
(74) Representative: Brötz, Helmut
(86) International application number: PCT/CN2019/070701
(87) International publication number: WO 2019/205741

(57) **Abstract**

An organic light emitting transistor and a manufacturing method thereof, a display panel and an electronic device are provided, and the organic light emitting transistor (100) includes a gate electrode (101), a gate insulation layer (102), an active layer (103), a source electrode (105) and a drain electrode (106); the active layer (103) includes a two-dimensional semiconductor material layer (1031) and an organic light emitting layer (1032), the two-dimensional semiconductor material layer (1031) and the organic light emitting layer (1031) are stacked to form a heterojunction, and the heterojunction is a heterotype heterojunction. The organic light emitting transistor (100) can improve a carrier mobility and thus improve performances of a device including the organic light emitting transistor by using the two-dimensional semiconductor material layer (1031) to form the heterojunction.

## Description

The application claims priority to the Chinese patent application No. 201810388274.0, filed on April 26, 2018, the entire disclosure of which is incorporated herein by reference as part of the present application.

### TECHNICAL FIELD

At least one embodiment of the present disclosure relates to an organic light emitting transistor and a manufacturing method thereof, a display panel and an electronic device.

### BACKGROUND

An organic light-emitting transistor (OLET) has a great potential application value in the fields of flat panel display, optical communication, solid-state illumination and electrically pumped organic laser because it has both a circuit modulation function of an organic field-effect transistor (OFET) and a light-emitting function of an organic light-emitting diode (OLED).

### SUMMARY

At least one embodiment of the present disclosure provides an organic light emitting transistor, and the organic light emitting transistor comprises a gate electrode, a gate insulation layer, an active layer, a source electrode, and a drain electrode, and the active layer comprises a two-dimensional semiconductor material layer and an organic light emitting layer, the two-dimensional semiconductor material layer and the organic light emitting layer are stacked to form a heterojunction, and the heterojunction is a heterotype heterojunction.

For example, in the organic light emitting transistor provided by at least one embodiment of the present disclosure, the heterojunction is a Van der Waals heterojunction.

For example, in the organic light emitting transistor provided by at least one embodiment of the present disclosure, the active layer further comprises an auxiliary organic layer, and the auxiliary organic layer is at a side of the organic light emitting layer away from the two-dimensional semiconductor material layer.

For example, in the organic light emitting transistor provided by at least one embodiment of the present disclosure, the auxiliary organic layer is a hole transport layer, and the two-dimensional semiconductor material layer is an electron transport layer.

For example, in the organic light emitting transistor provided by at least one embodiment of the present disclosure, a material of the two-dimensional semiconductor material layer comprises molybdenum sulfide, tungsten sulfide or boron nitride.

For example, in the organic light emitting transistor provided by at least one embodiment of the present disclosure, the gate electrode is a conductive silicon substrate, and the gate insulation layer and the active layer are sequentially formed on the conductive silicon substrate.

For example, the organic light emitting transistor provided by at least one embodiment of the present disclosure further comprises an auxiliary electrode layer, and the auxiliary electrode layer is at a side of the conductive silicon substrate away from the gate insulation layer, and the auxiliary electrode layer is in an ohmic contact with the conductive silicon substrate.

For example, in the organic light emitting transistor provided by at least one embodiment of the present disclosure, the source electrode/ the drain electrode is between the gate insulation layer and the active layer, or, the active layer is between the source electrode/ the drain electrode and the gate insulation layer.

For example, the organic light emitting transistor provided by at least one embodiment of the present disclosure further comprises a base substrate, and the organic light emitting transistor is a top-gate structure, and the active layer is between the gate electrode and the base substrate.

For example, in the organic light emitting transistor provided by at least one embodiment of the present disclosure, the source electrode/ the drain electrode is between the gate insulation layer and the active layer, or the active layer is between the source electrode/ the drain electrode and the gate insulation layer, or, the source electrode/ the drain electrode is on a same layer as the gate electrode.

At least one embodiment of the present disclosure further provides a display panel, and the display panel comprises a plurality of pixel units arranged in an array, and each of the pixel units comprises any one of the organic light emitting transistors mentioned above.

At least one embodiment of the present disclosure further provides an electronic device, and the electronic device comprises any one of the organic light emitting transistors mentioned above or the display panel mentioned above.

At least one embodiment of the present disclosure further provides a manufacturing method of an organic light emitting transistor, and the manufacturing method comprises: forming a gate electrode, a gate insulation layer, an active layer, a source electrode and a drain electrode, and forming the active layer comprises: forming a two-dimensional semiconductor material layer and an organic light emitting layer, the two-dimensional semiconductor material layer and the organic light emitting layer are stacked to form a heterojunction, and the heterojunction is a heterotype heterojunction.

For example, in the manufacturing method provided by at least one embodiment of the present disclosure, after forming the two-dimensional semiconductor material layer, an organic light emitting layer material is formed on the two-dimensional semiconductor material layer, and the organic light emitting layer material epitaxially grows along a crystalline phase of the two-dimensional semiconductor material layer to form the organic light emitting layer.

For example, in the manufacturing method provided by at least one embodiment of the present disclosure, a material of the two-dimensional semiconductor material layer comprises molybdenum sulfide, tungsten sulfide or boron nitride.

For example, in the manufacturing method provided by at least one embodiment of the present disclosure, forming the gate electrode comprises: providing a silicon substrate; performing a conducting treatment on the silicon substrate to form a conductive silicon substrate so that the conductive silicon substrate acts as the gate electrode, in which the gate insulation layer and the active layer are sequentially formed on the conductive silicon substrate.

For example, in the manufacturing method provided by at least one embodiment of the present disclosure, an auxiliary electrode layer is formed at a side of the conductive silicon substrate away from the gate insulation layer, and the auxiliary electrode layer is in an ohmic contact with the conductive silicon substrate.

For example, the manufacturing method provided by at least one embodiment of the present disclosure further comprises: providing a base substrate and forming the active layer, the gate insulation layer and the gate electrode on the base substrate sequentially.

For example, in the manufacturing method provided by at least an embodiment of the present disclosure, after forming the organic light emitting layer, the two-dimensional semiconductor material layer is formed on the organic light emitting layer by a transfer printing method.

For example, in the manufacturing method provided by at least an embodiment of the present disclosure, forming the active layer further comprises: forming an auxiliary organic layer at a side of the organic light emitting layer away from the two-dimensional semiconductor material layer.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1 is a cross-sectional structural schematic diagram of an organic light emitting transistor provided by an embodiment of the present disclosure;
FIG. 2 is a cross-sectional structural schematic diagram of an organic light emitting transistor provided by a modified embodiment of the present disclosure;
FIG. 3 is a cross-sectional structural schematic diagram of an organic light emitting transistor provided by another modified embodiment of the present disclosure;
FIG. 4 to FIG.7 are cross-sectional structural schematic diagrams of organic light emitting transistors with different structures provided by embodiments of the present disclosure;
FIG. 8 is a plane schematic diagram of a display panel provided by at least one embodiment of the present disclosure;
FIG. 9 is a schematic diagram of a pixel circuit provided by an embodiment of the present disclosure;
FIG. 10 is a schematic diagram of a pixel circuit provided by another embodiment of the present disclosure;
FIG. 11 is a schematic diagram of an electronic device provided by at least one embodiment of the present disclosure; and
FIG. 12 is a flow diagram of a manufacturing method of an organic light emitting transistor provided by at least one embodiment of the present disclosure.

### DETAILED DESCRIPTION

In order to make objects, technical details and advantages of the embodiments of the present disclosure apparent, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment (s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, "a," "an" or "the" are not intended to indicate a limitation of quantity, but indicate a presence of at least one. The terms "comprise," "comprising," "include," "including," etc., are intended to specify that the elements or the objects stated before these terms encompass the elements or the objects and equivalents thereof listed after these terms, but do not preclude the other elements or objects. The phrases "connect," "connected," etc., are not intended to define a physical connection or mechanical connection, but may include an electrical connection, directly or indirectly. "On," "under," "left," "right" and the like are only used to indicate relative position relationship, and when the position of the object which is described is changed, the relative position relationship may be changed accordingly.

A bipolar organic light-emitting transistor is a type of an organic light-emitting transistor, which uses a P-type material providing holes and an N-type material providing electrons to form a heterotype heterojunction, thus both an electron transport and an hole transport are realized at the same time. However, most of the N-type materials providing electrons have disadvantages of both a low carrier mobility and a poor material stability.

A two-dimensional (2D) material refers to a material that electrons can move freely (move in a plane) only in two dimensions with a non-nanometer scale, and a nanometer scale refers to a size of 1 nm to 100 nm. Two-dimensional material layers are bonded together only by weak Van der Waals force. A PN junction formed by a two-dimensional material layer and an other material layer by Van der Waals force is called as a Van der Waals heterojunction. An existence of Van der Waals force on a surface of a two-dimensional semiconductor material layer makes an interface of the Van der Waals heterojunction smoother, so that a roughness and a defect state density of the interface of the Van der Waals heterojunction are reduced, a carrier mobility is improved, and thus performances of a device including the two-dimensional semiconductor material layer is improved.

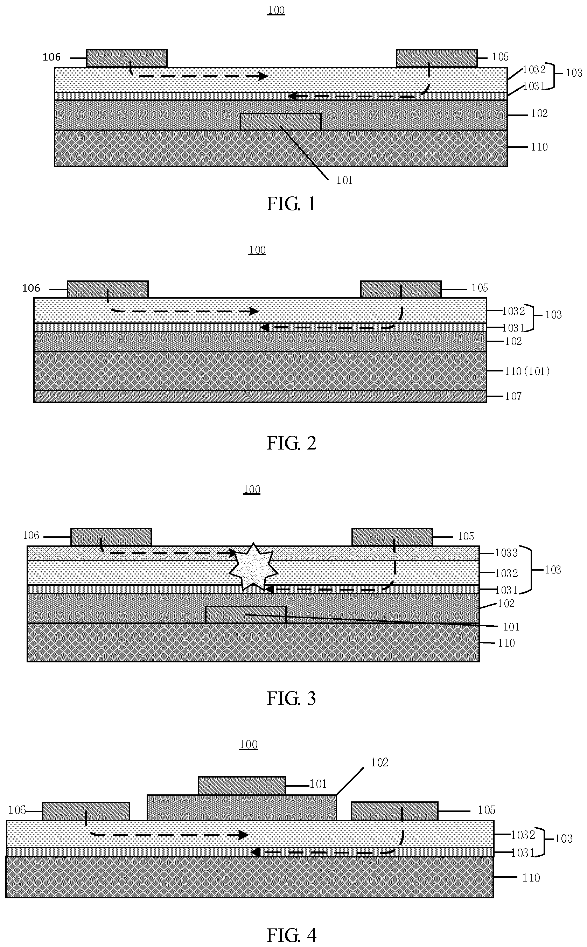

FIG. 1 is a cross-sectional structural schematic diagram of an organic light emitting transistor 100 provided by an embodiment of the present disclosure. The organic light emitting transistor 100 comprises a gate electrode 101, a gate insulation layer102, an active layer 103, a source electrode 105 and a drain electrode 106, and the gate electrode 101, the gate insulation layer 102, the active layer 103, the source electrode 105 and the drain electrode 106 are sequentially stacked on a substrate 101. The active layer 103 includes a two-dimensional semiconductor material layer 1031 and an organic light emitting layer 1032, and the two-dimensional semiconductor material layer 1031 and the organic light emitting layer 1032 constitute a heterotype heterojunction. For example, a material of the two-dimensional semiconductor material layer 1031 is an N-type material, a material of the organic light emitting layer 1032 is a P-type material, and the heterojunction is a Van der Waals heterojunction.

A working principle of the organic light emitting transistor includes: electrons and holes are injected into the active layer 103 from the source electrode 105 and the drain electrode 106 respectively under an action of a voltage applied to the gate electrode 101 and a voltage applied to at least one of the source electrode and the drain electrode. At this time, the two-dimensional semiconductor material layer 1031 plays a role of transporting electrons, and the electrons are transported in the two-dimensional semiconductor material layer 1031 and move toward the drain electrode 106, as illustrated by a direction represented by a dashed line on a right side in FIG. 1; the organic light emitting layer 1032 also plays a role of transporting holes, and the holes are transported in the organic light emitting layer 1032 and move toward the source electrode 105, as illustrated by a direction represented by the dashed line on a left side in FIG. 1. At a place where the electrons and the holes meet, the electrons easily enter a HOMO energy level of a material of the organic light emitting layer 1032 from a HOMO energy level of a material of the two-dimensional semiconductor material layer 1031 to form excitons with the holes and finally the excitons transition to realize radio luminescence.

In the heterojunction, by using the two-dimensional semiconductor material layer 1031 as an electron transport layer, the interface of the heterojunction is smoother, the roughness and the defect state density of the interface of the heterojunction are reduced, thus the carrier mobility is improved, and further the performances of the device including the two-dimensional semiconductor material layer is improved. In the embodiment of the present disclosure, the two-dimensional semiconductor material layer 1031 is closer to the gate insulation layer 102, however, the embodiments of the present disclosure do not limit the stacking order of the two-dimensional semiconductor material layer 1031 and the organic light emitting layer 1032 in the active layer 103, that is, the organic light emitting layer 1032 may be closer to the gate insulation layer 102 than the two-dimensional semiconductor material layer 1031.

For example, a material of the two-dimensional semiconductor material layer 1031 includes a two-dimensional semiconductor material such as molybdenum sulfide (MoS₂), tungsten sulfide (WS₂), boron nitride (BN) and so on.

For example, a material of the organic light emitting layer 1032 includes an organic light emitting material such as poly (9,9'-dioctylfluorene-alternating-benzothiadiazole) (F8BT), tetraphenylene, pentacene, tris (8-hydroxyquinoline) aluminum: 4-(dicyanomethylene)-2-methyl-6-(4-dimethylaminos-tyryl)-4H-pyran (Alq3:DCM), bis(2-methyl-8-quinolinolato-N1,O8)-(1,1'-biphenyl-4-olato)aluminum (Balq), 4'4'-bis (9-carbazolyl)-2,2'-dimethylbiphenyl (CDBP), 9,10-di-(2-naphthyl)anthracene (ADN), 3-phenyl-4-(1'-naphthyl)-5-phenyl-1,2,4-triazole (TAZ), 4,4'-bis(carbazol-9-yl)biphenyl (CBP), N,N'-dicarbazolyl-2,5-benzene (mCP), N,N'-dicarbazolyl-1,4-dimethene-benzene (DCB), 4,4',4"-tris(carbazol-9-yl)-triphenylamine (TCTA), 2,9-dimethyl-4-7-dimethylphenanthroline (BCP), N,N-bis (a-naphthyl-phenyl) -4,4-biphenyldiamine (NPB), 1,3-bis(N,N-tert-butylphenyl)-1,3,4-oxadiazole(OXD7), N,2,6-dibromophenyl-1,8- naphthalimide (niBr) or 2,4-6-tricarbazole-1, 3,5-triazine (TRZ).

For example, a material of the substrate 110 is glass, quartz, sapphire or a flexible organic material such as polyethylene terephthalate (PET). In a case that the material of the substrate 110 is quartz or sapphire, because both the sapphire and the quartz have a single crystal structure, a material layer grown thereon can epitaxially grow to have a good orientation.

For example, a material of the gate electrode 101 includes at least one of gold (Au), silver (Ag), copper (Cu), aluminum (Al), molybdenum (Mo), magnesium (Mg) or an alloy material formed by a combination of at least two of the above metals.

For example, a material of the gate insulation layer 102 includes inorganic insulation materials such as silicon nitride, silicon oxynitride, aluminum oxide and so on, or organic insulation materials such as acrylic acid, polymethyl methacrylate (PMMA) and so on.

For example, both a material of the source electrode 105 and a material of the drain electrode 106 include at least one of gold (Au), silver (Ag), copper (Cu), aluminum (Al), molybdenum (Mo), magnesium (Mg) and alloy materials formed by a combination of at least two of the above metals.

For example, both the material of the source electrode 105 and the material of drain electrode 106 also include a conductive metal oxide, such as indium tin oxide (ITO), indium zinc oxide (IZO), zinc oxide (ZnO), aluminum zinc oxide (AZO), and the like.

For example, the source electrode 105 and the drain electrode 106 are made of a same material to simplify a manufacturing process of the organic light emitting transistor.

For example, the source electrode 105 and the drain electrode 106 are made of different materials. Because the source electrode 105 and the drain electrode 106 are configured to inject the electrons and the holes respectively, conductive materials with different work functions can be selected as the materials of the source electrode 105 and the drain electrode 106 respectively, thus to obtain a higher carrier current density. For example, a material with a lower work function is used as the material of the source electrode 105, and a material with a higher work function is used as the material of the drain electrode 106. For example, aluminum or magnesium are used as the material of the source electrode 105, and gold or ITO are used as the material of the drain electrode 106.

It should be noted that, in at least one embodiment of the present disclosure, one electrode of the organic light emitting transistor 100 for injecting electrons is referred to as the source electrode 105, and one electrode for injecting holes is referred to as the drain electrode 106. In other embodiments of the present disclosure, the names of the source electrode and the drain electrode are interchangeable according to custom, that is, one electrode for injecting electrons is referred to as the drain electrode 106, and one electrode for injecting holes is referred to as the source electrode 105, which are not limited in the embodiments of the present disclosure.

In a modified embodiment, as illustrated in FIG. 2, the gate electrode 101 and the substrate 110 are integrated, for example, the substrate 110 is a conductive silicon substrate which is treated to be conductive, and the conductive silicon substrate 110 also serves as the gate electrode 101 of the organic light emitting transistor. For example, the silicon substrate is a silicon wafer (epitaxial silicon wafer) or a silicon-on-insulator (SOI) substrate or the like. For example, the conductive silicon substrate is an N-type heavily doped silicon wafer. For example, the N-type heavily doped silicon wafer includes monocrystalline silicon doped with an element P (phosphorus), and a concentration of the element P is greater than 1 × 10¹⁵ cm⁻³. That is, the N-type heavily doped silicon wafer serves as both the substrate 110 and the gate electrode 101 of the organic light emitting transistor 100, the gate insulation layer 102, the active layer 103, the source electrode 105 and the drain electrode 106 are sequentially formed on the N-type heavily doped silicon wafer. For example, in order to increase a flatness of a surface of the silicon wafer, a surface of the N-type heavily doped silicon wafer which is used for forming a structure of the organic light emitting transistor 100 is polished, and for example, a polishing process is a chemical polishing process or a mechanical polishing process. In this way, the manufacturing process of the organic light emitting transistor 100 can be compatible with a silicon-based process, which is helpful to realize a higher resolution (PPI).

For example, in a case that the silicon substrate serves as the gate electrode 101, a surface of the gate electrode 101 is treated to form silicon oxide, for example, a heat treatment is performed directly on the surface of the silicon substrate to form silicon oxide which acts as the gate insulation layer 102 by a thermal growth method. The gate insulation layer 102 may also be formed by other processes and materials, for example, a silicon nitride layer may be formed by a chemical vapor deposition (CVD) method to form the gate insulation layer 102.

For example, as illustrated in FIG. 2, in a case that the silicon substrate serves as the gate electrode 101, the organic light emitting transistor 100 further includes an auxiliary electrode layer 107. The auxiliary electrode layer 107 is at a side of the N-type heavily doped silicon wafer away from the gate insulation layer 102. The auxiliary electrode layer 107 is in an ohmic contact with the heavily doped silicon wafer to reduce a resistance of the gate electrode 101. For example, a material of the auxiliary electrode layer 107 is aluminum, aluminum alloy, copper, copper alloy, magnesium, or the like.

In another modified embodiment, as illustrated in FIG. 3, the active layer 103 of the organic light emitting transistor 100 further includes an auxiliary organic layer 1033, and the auxiliary organic layer 1033 is at a side of the organic light emitting layer 1032 away from the two-dimensional semiconductor material layer 1031. For example, as illustrated in FIG. 3, the auxiliary organic layer 1033 is between the organic light emitting layer 1032 and the source electrode 105, and between the organic light emitting layer 1032 and the drain electrode 106, and the auxiliary organic layer 1033 is in direct contact with the source electrode 105 and the drain electrode 106.

For example, the auxiliary organic layer 1033 is a hole transport layer, and by separately arranging the hole transport layer, a process of transporting the carriers is separated from a process of compound illuminating, and a light emitting efficiency of the organic light emitting transistor 100 is improved. In the embodiment of the present disclosure, the auxiliary organic layer 1033 can also keep the organic light emitting layer 1032 far away from the source electrode 105 and the drain electrode 106, which effectively reduces quenching of excitons and exciton-carrier caused by electrodes formed by metal materials such as the source electrode 105 and the drain electrode 106, and further improves the light emitting efficiency of the organic light emitting transistor 100. In a case that the organic light emitting transistor 100 is in operation, a large number of holes are injected into the auxiliary organic layer 1033, and a large number of electrons are injected into the two-dimensional semiconductor material layer 1031. The electrons and the holes move in opposite directions under the voltage applied to the source electrode and the voltage applied to the drain electrode, and the electrons meet the holes in the organic light emitting layer 1032 which is between the auxiliary organic layer 1033 and the two-dimensional semiconductor material layer 1031 to form excitons which transition to realize radio luminescence.

For example, a material of the auxiliary organic layer 1033 includes a material with a hole transport function such as 3,3'''-dihexyl-2,2':5',2":5",2'''-tetrathiophene (DH4T), pentacene, rubrene, 9,10-di-(2-naphthyl)anthracene (ADN), 4,4',4"-tris(carbazol-9-yl)-triphenylamine (TCTA), N,N'-bis-(1-naphthalenyl)-N,N'-bis-phenyl-(1,1'-biphenyl)-4,4'-diamine (NPB) or 4,4',4"-tri-(3-methylphenylanilino)triphenylamine (m-MTDATA), and the like.

In the embodiments of the present disclosure and the modified embodiments, the organic light emitting transistor 100 is a bottom-gate top contact structure, the active layer 103 is between the gate electrode 101 and the substrate 110, and the active layer 103 is between the source electrode 105/ the drain electrode 106 and the gate insulation layer 102. However, the structure of the organic light emitting transistor 100 is not limited in the embodiment of the present disclosure. For example, the organic light emitting transistor 100 may also be a bottom-gate bottom contact structure. A difference between the bottom-gate bottom contact structure and the bottom-gate top contact structure is that the source electrode 105/ the drain electrode 106 is disposed between the active layer 103 and the gate insulation layer 102. For example, the organic light emitting transistor 100 may also be other types of structures such as a top-gate bottom contact type and a top-gate top contact type. Those skilled in the art should understand that as long as the active layer 103 of the organic light emitting transistor 100 includes a two-dimensional semiconductor material for forming a heterotype heterojunction, the organic light emitting transistor 100 falls within the protection scope of the present disclosure. In the following, the organic light emitting transistors with other structures provided by the embodiments of the present disclosure are described as examples with reference to FIG. 4 to FIG. 7.

FIG. 4 is an organic light emitting transistor with a top-gate top contact structure provided by an embodiment of the present disclosure. As illustrated in FIG. 4, the active layer 103, the gate insulation layer 102, the gate electrode 101, the source electrode 105 and the drain electrode 106 of the organic light emitting transistor 100 are sequentially stacked on the substrate 110. The active layer 103 is closer to the substrate 110 than the gate electrode 101. The active layer 103 includes a two-dimensional semiconductor material layer 1031 and an organic light emitting layer 1032, the two-dimensional semiconductor material layer and the organic light emitting layer are stacked to form the heterotype heterojunction.

For example, the substrate 110 is made of a transparent material or a semi-transparent material, and the organic light emitting transistor 100 is a bottom light emitting structure. For example, a material of the substrate 110 is sapphire or quartz.

For example, the gate electrode 101 is made of a transparent material or a semi-transparent material, and the organic light emitting transistor 100 is a top light emitting structure. For example, the gate electrode 101 is made of a transparent conductive oxide material, such as indium tin oxide (ITO), indium zinc oxide (IZO), zinc oxide (ZnO), aluminum zinc oxide (AZO) and the like.

For example, the substrate 110 is made of a material having a single crystal structure such as sapphire or quartz. Because the substrate made of the material having the single crystal structure has a good orientation, a film structure formed thereon can epitaxially grow to have a better lattice structure and fewer defects.

For example, in a case that the substrate 110 is made of the material having the single crystal structure such as sapphire or quartz, the two-dimensional semiconductor material layer is directly disposed on the substrate 110, for example, the two-dimensional semiconductor material layer is in direct contact with the substrate 110, and thus a better orientation is obtained.

In at least one embodiment of the present disclosure, the gate electrode 101, the source electrode 105 and the drain electrode 106 are disposed in a same layer, for example, the gate electrode 101, the source electrode 105 and the drain electrode 106 are formed by depositing a same conductive material in a same process and formed by a same patterning process. In other embodiments, for example, in the top-gate top contact structure, the source electrode 105 and the drain electrode 106 are between the gate insulation layer 102 and the active layer 103, or in the top-gate bottom contact structure, the active layer 103 is between the gate insulation layer 102 and both the source electrode 105 and the drain electrode 106.

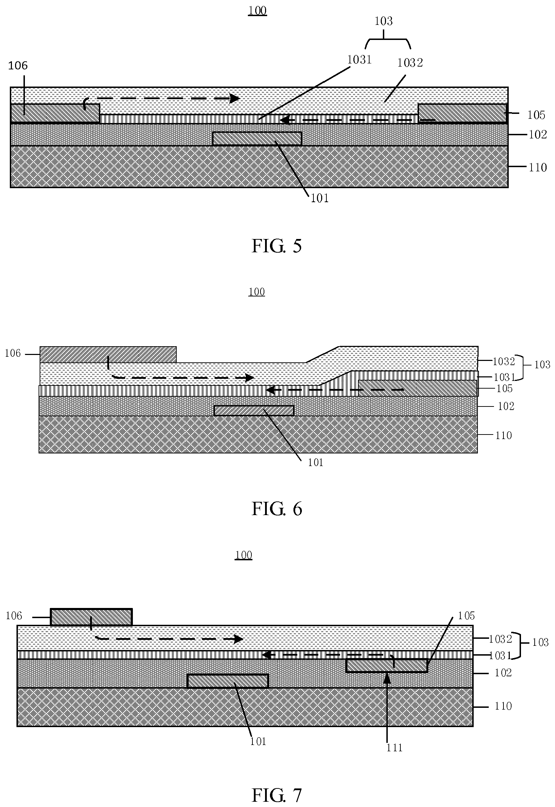

FIG. 5 is a schematic diagram of an organic light emitting transistor provided by another embodiment of the present disclosure. As illustrated in FIG. 5, the source electrode 105 and the drain electrode 106 are at a side of the organic light emitting layer 1032 close to the gate electrode 101. At the same time, in order to improve the flatness of the interface between the two-dimensional semiconductor material layer 1031 and the gate insulation layer 102, the two-dimensional semiconductor material layer 1031 is disposed between the source electrode 105 and the drain electrode 106. In this structure, both the source electrode 105 and the drain electrode 106 are in direct contact with both the two-dimensional semiconductor material layer 1031 and the organic light emitting layer 1032, so that the electrons are directly injected into the two-dimensional semiconductor material layer 1031 (an electron transport layer) from the source electrode 105, and the holes are directly injected into the organic light emitting layer (a hole transport layer) 1032 from the drain electrode 106, so that a length of the channel region is reduced, a driving voltage is reduced and a driving current is increased.

FIG. 6 is a cross-sectional structural schematic diagram of an organic light emitting transistor 100 provided by still another embodiment of the present disclosure. As illustrated in FIG. 6, the source electrode 105 of the organic light emitting transistor is at a side of the two-dimensional semiconductor material layer 1031 away from the organic light emitting layer 1032. The drain electrode 106 is at the side of the organic light-emitting layer 1032 away from the two-dimensional semiconductor material layer 1031. The source electrode 105 is in direct contact with the two-dimensional semiconductor material layer 1031, and the drain electrode 106 is in direct contact with the organic light-emitting layer 1032, so that the electrons are directly injected into the two-dimensional semiconductor material layer 1031 from the source electrode 105 and the holes are directly injected into the organic light-emitting layer 1032 (a hole transport layer) from the drain electrode 106, and thus a length of the channel region is reduced, a driving voltage is reduced, and a driving current is increased.

In still another embodiment of the present disclosure, as illustrated in FIG. 7, the gate insulation layer 102 is provided with a groove 111. In order to improve the flatness of the interface between the two-dimensional semiconductor material layer 1031 and the gate insulation layer 102, the source electrode 105 is disposed in the groove 111 of the gate insulation layer 102.

The organic light emitting transistor 100 has various applications as a combination of a field effect transistor and an organic light emitting diode.

The embodiment of the present disclosure further provides a display panel, and the display panel includes any one of the organic light emitting transistors 100 mentioned above. The following is described in detail by taking the display panel as an organic light emitting diode display panel as an example.

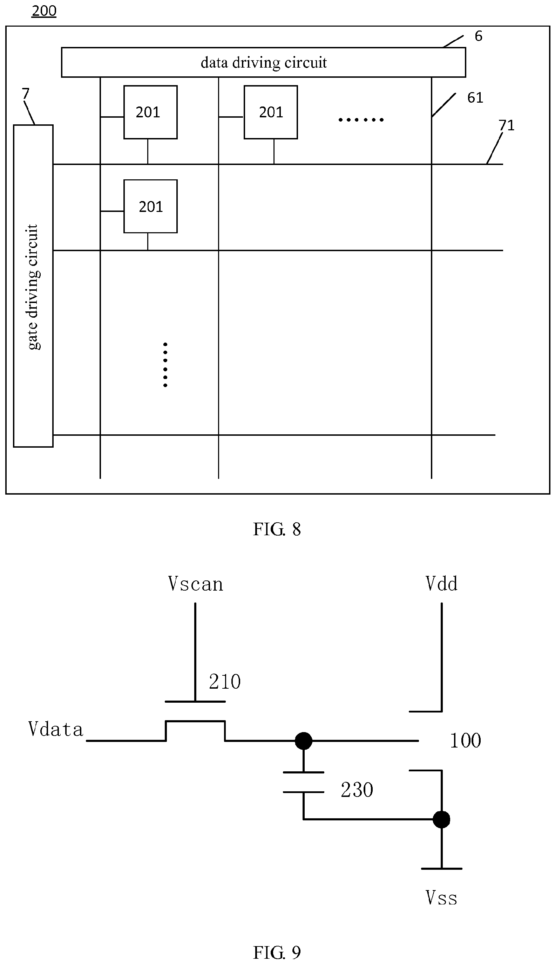

FIG. 8 is a schematic plane view of a display panel 200 provided by an embodiment of the present disclosure. The display panel 200 includes a plurality of gate lines 71, a plurality of data lines 61 and a plurality of pixel units 201 arranged in an array. The plurality of the gate lines 71 and the plurality of the data lines 61 are intersected with each other to define a plurality of pixel regions. The plurality of the pixel units 201 are distributed in the plurality of the pixel regions in one-to-one correspondence, and each of the pixel units 201 includes at least one organic light emitting transistor 100 and a pixel circuit connected with the organic light emitting transistor 100. The organic light emitting transistor 100 emits light under the driving of the pixel circuit.

For example, as illustrated in FIG. 8, the display panel 200 further includes a data driving circuit 6 and a gate driving circuit 7, the data driving circuit 6 is configured to provide a data signal (for example, a signal Vdata) and the gate driving circuit 7 is configured to provide a scanning signal (for example, a signal Vscan), and the data driving circuit 6 and the gate driving circuit 7 are further used for providing various control signals. The data driving circuit 6 is connected with the pixel units 201 by the data lines 61, and the gate driving circuit 7 is connected with the pixel units 201 by the gate lines 71.

The pixel circuit is described below in connection with specific embodiments. It should be noted that, because the source electrode and the drain electrode of the field effect transistor are symmetrical in a physical structure thereof, the source electrode and the drain electrode of the field effect transistor (for example, a thin film transistor) referred to below can be interchanged.

FIG. 9 is a schematic diagram of a pixel circuit provided by an embodiment of the present disclosure. As illustrated in FIG. 8 and FIG. 9, each of the pixel units 201 includes a first thin film transistor 210, a capacitor 230 and the organic light emitting transistor 100. A source electrode of the first thin film transistor 210 is connected to one of the data lines to receive the data signal Vdata, a gate electrode of the first thin film transistor 210 is connected to one of the gate lines to receive the scanning signal Vscan, and a drain electrode of the first thin film transistor 210 is connected to the gate electrode of the organic light emitting transistor 100 and one end of the capacitor 230 to maintain a voltage. The other end of the capacitor 230 is connected to a first power supply terminal Vss (a low voltage terminal, for example, ground). The source electrode of the organic light emitting transistor 100 is also connected to the first power supply terminal Vss, and the drain electrode of the organic light emitting transistor 100 is connected to a second power supply terminal Vdd (a high voltage terminal).

A working process of the pixel circuit is as follows: in a case that the first thin film transistor 210 is turned on under an action of the scanning signal Vscan, the data signal Vdata is transmitted to the drain electrode of the first thin film transistor 210 and the data signal Vdata is converted into an electrical signal to be stored in the capacitor 230. Because the capacitor 230 has a bootstrap effect, even if the first thin film transistor 210 is turned off, the gate electrode of the organic light emitting transistor 100 can continue to receive a certain voltage signal under an action of the electrical signal stored in the capacitor 230. Meanwhile, because an action of the first power supply terminal Vss and an action of the second power supply terminal Vdd, the source electrode of the organic light emitting transistor 100 is electrically connected with the drain electrode of the organic light emitting transistor 100, and thus the organic light emitting transistor 100 emits light.

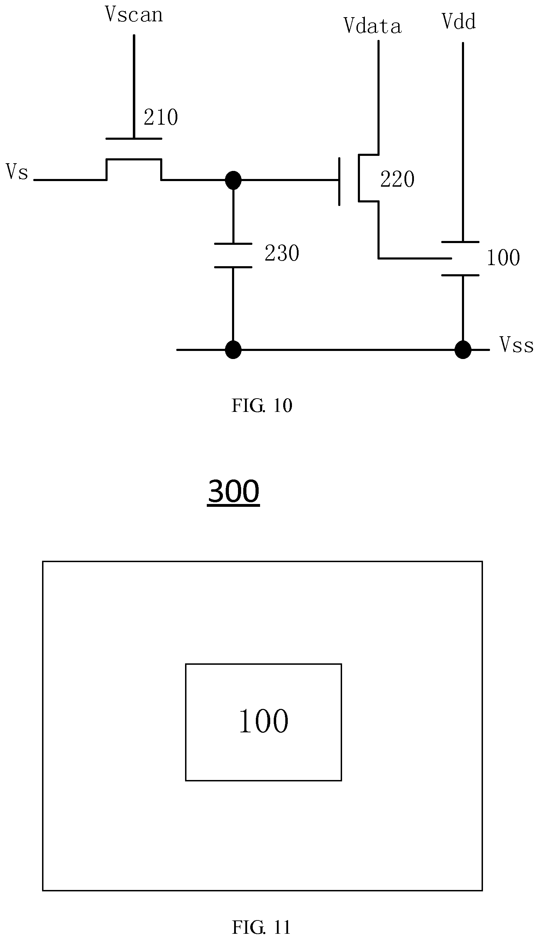

FIG. 10 is a schematic diagram of a pixel circuit provided by another embodiment of the present disclosure. A difference between the embodiment illustrated in FIG. 10 and the embodiment illustrated in FIG. 9 is that the pixel circuit in the embodiment illustrated in FIG. 10 further includes a second thin film transistor 220. The second thin film transistor 220 is disposed between the first thin film transistor 210 and the organic light emitting transistor 100. For example, a gate electrode of the second thin film transistor 220 is connected to the drain electrode of the first thin film transistor 210 and one end of the capacitor 230, a drain electrode of the second thin film transistor 220 is connected to the gate electrode of the organic light emitting transistor 100, and a source electrode of the second thin film transistor 220 is connected to one of the data lines to receive the data signal Vdata. The first thin film transistor 210 is connected to a switching signal line to receive a switching signal Vs. This structure reduces an influence of an attenuation of charges stored in the capacitor 230 on the data signal received by the organic light emitting transistor 100.

A working process of the pixel circuit is as follows: in a case that the first thin film transistor 210 is turned on under an action of the scanning signal Vscan, the switching signal Vs is transmitted to the drain electrode of the first thin film transistor 210 and converted into charges to be stored in the capacitor 230. Because of the bootstrap effect of the capacitor 230, even if the first thin film transistor 210 is turned off, the gate electrode of the organic light emitting transistor 100 can continue to receive a certain voltage signal and remain a state of turnning on under an action of an electrical signal stored in the capacitor 230. Therefore, the data signal Vdata is transmitted to the drain electrode of the second thin film transistor 220, that is, the gate electrode of the organic light emitting transistor 100. Meanwhile, because of an action of the first power supply terminal Vss and an action of the second power supply terminal Vdd, the source electrode is electrically connected with the drain electrode of the organic light emitting transistor 100, and thus the organic light emitting transistor 100 emits light. In this circuit, as long as the electrical signal stored in the capacitor 230 can enable the second thin film transistor 220 to keep on, the data signal Vdata can be directly transmitted to the gate electrode of the organic light emitting transistor 100 without being affected by an attenuation of the electrical signal stored in the capacitor 230.

At least one embodiment of the present disclosure further provides an electronic device, and the electronic device includes any one of the organic light emitting transistors mentioned above or any one of the display panels mentioned above. As illustrated in FIG. 11, the electronic device 300 includes any one of the organic light emitting transistors 100 mentioned above. The electronic device, for example, is an electronic device using the organic light emitting transistor such as a display device, an optical communication device, a solid state lighting device and an electrically pumped organic laser.

At least one embodiment of the present disclosure further provides a manufacturing method of the above-mentioned organic light emitting transistor, and the method at least includes: forming a gate electrode, a gate insulation layer, an active layer, a source electrode and a drain electrode, the active layer comprises a two-dimensional semiconductor material layer and an organic light emitting layer, the two-dimensional semiconductor material layer and the organic light emitting layer are stacked to form a heterojunction, and the heterojunction is a heterotype heterojunction.

For example, organic light emitting transistors with different structures such as a bottom-gate top contact type, a bottom-gate bottom contact type, a top-gate bottom contact type, a top-gate top contact type and a top-gate top contact type and so on are formed according to different formation sequences of the gate electrode, the active layer, the source electrode and the drain electrode.

For example, the gate electrode is served by a conductive silicon substrate. For example, the silicon substrate is a silicon wafer (an epitaxial silicon wafer) or a silicon-on-insulator (SOI) substrate or the like. That is, the conductive silicon substrate serves as both the substrate and the gate electrode of the organic light emitting transistor, and the gate insulation layer, the active layer, the source electrode and the drain electrode are formed on the conductive silicon substrate. In this way, the manufacturing process of the organic light emitting transistor is compatible with the silicon-based process, which is helpful to realize a higher resolution (PPI).

For example, the organic light emitting transistor is formed on a substrate made of glass, quartz, sapphire or a flexible organic substrate (for example, a PET substrate).

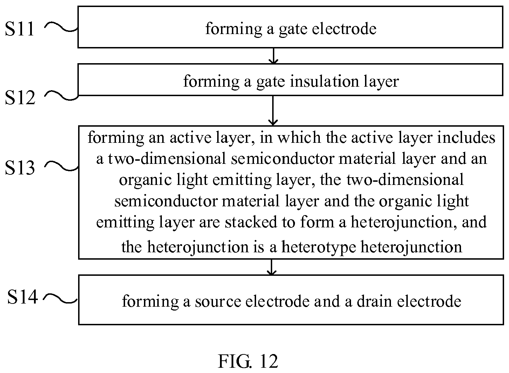

The following is illustrated by taking the conductive silicon wafer as the gate electrode for example, and combining with FIG. 2 and FIG. 12, a manufacturing method of the organic light emitting transistor is exemplarily illustrated by taking a case that the conductive silicon wafer serves as the gate electrode as an example. The manufacturing method of the organic light emitting transistor comprises:
Step S11: forming a gate electrode 101.

In at least one embodiment of the present disclosure, a conducting treatment is performed on the silicon wafer to make the silicon substrate conductive to form a gate electrode 101 of the organic light emitting transistor. In other embodiments, the gate electrode is formed by depositing a conductive material directly on the silicon wafer, for example, the conductive material includes gold (Au), silver (Ag), copper (Cu), aluminum (Al), molybdenum (Mo), magnesium (Mg), and alloy materials formed by a combination of the above metals.

For example, in order to increase a flatness of a surface of the silicon wafer, a polishing process is performed on a surface of the silicon wafer, which is used for forming the organic light emitting transistor structure. Of course, a polishing process may also be performed on both sides of the silicon wafer, which are not limited in the embodiments of the present disclosure. For example, the polishing process can be performed by a chemical mechanical polishing method.

For example, the conducting treatment includes performing an N-type heavy doping process on the silicon wafer. For example, the N-type heavy doping process includes doping the silicon wafer with an element P by an ion implantation process, in which a concentration of the element P is greater than 1 × 10¹⁵ cm⁻³. The doping step may also include an annealing process to repair a lattice damage caused by the ion implantation. For example, the annealing is performed at 450 °C with nitrogen as a shielding gas.

For example, in order to reduce a resistance of the gate electrode, an auxiliary electrode layer 107 is formed on the other side surface of the silicon wafer, that is, the unpolished surface. The auxiliary electrode layer 107 is in an ohmic contact with the silicon wafer. For example, the processes of forming the auxiliary electrode layer 107 include preparing a heavily doped region on the other side surface of the silicon wafer so that the auxiliary electrode layer 107 is in an ohmic contact with the silicon wafer. For example, the doping step includes doping the silicon wafer with the element P by the ion implantation process, in which a concentration of element P is greater than 1 × 10¹⁵ cm⁻³. The doping step may also include an annealing process to repair a lattice damage caused by the ion implantation. For example, the annealing is performed at 450 °C with nitrogen as a shielding gas.

For example, the auxiliary electrode layer 107 is formed by an evaporation process or a sputtering process. For example, a material of the auxiliary electrode layer 107 is aluminum.

Step S12: forming a gate insulation layer 102.

For example, a layer of silicon oxide is grown as the gate insulation layer 102 on the polished surface of the silicon wafer by a thermal growth method.

For example, the thermal growth method includes placing the silicon wafer in a thermal oxidation device, and heating to a certain temperature and introducing oxygen or water vapor to the polished surface of the silicon wafer, and then the silicon oxide is generated by a chemical reaction on the polished surface of the silicon wafer.

For example, a material of the gate insulation layer 102 is an inorganic insulating material such as silicon nitride, silicon oxynitride, aluminum oxide and so on, or an organic insulating material such as acrylic acid, polymethyl methacrylate (PMMA) and so on. The method of forming the gate insulation layer 102 includes other process methods such as a chemical vapor deposition method (for example, forming an inorganic insulation layer), a spin coating method (for example, forming an organic insulation layer) and so on.

Step S13: forming an active layer 103, in which the active layer 103 includes a two-dimensional semiconductor material layer 1031 and an organic light emitting layer 1032, the two-dimensional semiconductor material layer and the organic light emitting layer are stacked to form a heterojunction, and the heterojunction is a heterotype heterojunction.

For example, the two-dimensional semiconductor material layer 103 is formed by a method of magnetron sputtering method or a chemical vapor deposition method (CVD).

For example, a material of the two-dimensional semiconductor material layer 1031 includes two-dimensional semiconductor materials such as molybdenum sulfide (MoS₂), tungsten sulfide (WS₂), boron nitride (BN), and the like. For example, the two-dimensional semiconductor material layer 1031 is made of an N-type material.

Taking a case that the molybdenum sulfide is used as the material of the two-dimensional semiconductor material layer 1031 as an example, a two-dimensional molybdenum sulfide layer is formed by a method of magnetron sputtering or a method of ion intercalation. For example, the magnetron sputtering method includes sputtering to form an ultra-thin metal molybdenum layer, followed by high-temperature vulcanization to form the two-dimensional molybdenum sulfide layer. For example, the method of magnetron sputtering includes directly sputtering the molybdenum sulfide as a target to form the two-dimensional molybdenum sulfide layer.

For example, a method of ion intercalation includes the following operations: under an ultrasonic condition, molybdenum sulfide is stripped by utilizing a surface tension of a solvent, a single layer of molybdenum sulfide is dispersed in the solvent, and a two-dimensional molybdenum sulfide material is obtained after centrifugal drying.

For example, a method of lithium ion intercalation includes the following operations. Molybdenum sulfide powder is added into an n-hexane solution of n-butyl lithium, at this time, lithium ions are inserted into the molybdenum sulfide powder, and then a gas generated by a reaction of n-butyl lithium with water or other protic solvents increases a layer space of molybdenum sulfide, and thus a multi-layer molybdenum sulfide material or a single-layer molybdenum sulfide material is obtained. After this, a solvent in which a single layer of the molybdenum sulfide is dispersed is applied to the silicon wafer, and a required two-dimensional molybdenum sulfide layer is obtained after drying the silicon wafer.

For example, the organic light emitting layer 1032 is formed by evaporation.

For example, a material of the organic light emitting layer includes an organic light emitting material such as poly (9,9'-dioctylfluorene-alternating-benzothiadiazole) (F8BT), tetraphenylene, pentacene, tris (8-hydroxyquinoline) aluminum: 4-(dicyanomethylene)-2-methyl-6-(4-dimethylaminos-tyryl)-4H-pyran (Alq3:DCM), bis(2-methyl-8-quinolinolato-N1,O8)-(1,1'-biphenyl-4-olato)aluminum (Balq), 4'4'-bis (9-carbazolyl) -2,2'- dimethylbiphenyl (CDBP), 9,10-di-(2-naphthyl)anthracene (ADN), 3-phenyl-4- (1'- naphthyl) -5- phenyl-1,2,4- triazole (TAZ), 4,4'-bis(carbazol-9-yl)biphenyl (CBP), N,N'-dicarbazolyl-2,5-benzene (mCP), N,N'- dicarbazolyl-1,4-dimethene-benzene (DCB), 4,4',4"-tris(carbazol-9-yl)-triphenylamine (TCTA), 2,9-dimethyl-4-7-dimethylphenanthroline (BCP), N,N-bis (a-naphthyl-phenyl) -4,4-biphenyldiamine (NPB), 1,3-bis(N,N-tert-butylphenyl)-1,3,4-oxadiazole(OXD7), N,2,6-dibromophenyl-1,8-naphthalimide (niBr) or 2,4-6-tricarbazole-1,3,5-triazine (TRZ).

In at least one embodiment of the present disclosure, the two-dimensional semiconductor material layer 1031 is formed firstly, and then the organic light emitting layer 1032 is formed on the surface of the two-dimensional semiconductor material layer 1031. Because a Van der Waals force exists on the surface of the two-dimensional semiconductor material layer 1031, an organic light emitting layer material formed on the two-dimensional semiconductor material layer 1031 epitaxially grows along a crystal direction of the two-dimensional semiconductor material layer 1031 under an effect of the Van der Waals force, so that an interface of the heterojunction is smoother, a roughness and a defect state density of the interface of the Van der Waals heterojunction are reduced, a carrier mobility is improved, and thus performances of a device including the two-dimensional semiconductor material layer is improved. However, an order of forming the two-dimensional semiconductor material layer 1031 and the organic light emitting layer 1032 in the embodiments of the present disclosure is not limited in the embodiment of the present disclosure.

For example, the organic light emitting layer 1032 is formed firstly, and then the two-dimensional semiconductor material layer 1031 is formed on a surface of the organic light emitting layer 1032. For example, in order to prevent a temperature condition for forming the two-dimensional semiconductor material layer 1031 from adversely affecting the previously formed organic light emitting layer 1032, and also to obtain a high-quality two-dimensional semiconductor material layer 1031, the two-dimensional semiconductor material layer 1031 is formed on another substrate made of a high-temperature resistant material having a single crystal structure such as a sapphire substrate, a quartz substrate or a silicon wafer, and then the two-dimensional semiconductor material layer 1031 is formed on the surface of the organic light emitting layer 1032 by a transfer printing method. Because the substrate made of the single crystal structure material has a good orientation, the two-dimensional semiconductor material layer 1031 grows thereon can obtain a better lattice structure and fewer defects. For example, a silicon oxide layer is grown on a silicon wafer, and then the two-dimensional semiconductor material layer 1031 is formed on the silicon oxide layer, and then the silicon wafer is treated with hydrofluoric acid. Because of a corrosive effect of hydrofluoric acid on the silicon oxide layer, the two-dimensional semiconductor material layer 1031 can be detached from the silicon wafer, and finally the two-dimensional semiconductor material layer 1031 is transferred to the organic light emitting layer 1032.

Step S14: forming a source electrode 105 and a drain electrode 106.

For example, both a material of the source electrode 105 and a material of the drain electrode 106 include at least one of gold (Au), silver (Ag), copper (Cu), aluminum (Al), molybdenum (Mo), magnesium (Mg) and an alloy material formed by a combination of at least two of the above metals. For example, the material of the source electrode 105 and the material of the drain electrode 106 may also include a conductive metal oxide, such as indium tin oxide (ITO), indium zinc oxide (IZO), zinc oxide (ZnO), aluminum zinc oxide (AZO), and the like.

For example, the source electrode 105 and the drain electrode 106 are made of a same material and formed in a same patterning process, and thereby the process of manufacturing the organic light emitting transistor is simplified.

For example, the source electrode 105 and the drain electrode 106 are respectively made of different materials. For example, a material with a lower work function is used as the material of the source electrode 105, and a material with a higher work function is used as the material of the drain electrode 106. For example, aluminum or magnesium is used as the material of the source electrode 105, and gold or ITO are used as the material of the drain electrode 106.

In another embodiment of the present disclosure, the manufacturing method further includes forming an auxiliary organic layer 1033 on a side of the organic light emitting layer 1032 away from the two-dimensional semiconductor material layer 1031. For example, the auxiliary organic layer 1033 is a hole transport layer, and a light emitting efficiency of the organic light emitting transistor is improved by separately arranging the auxiliary organic layer 1033 to separate a process of transporting the carriers from a process of compound illuminating. For example, in at least one embodiment of the present disclosure, the auxiliary organic layer is formed between the organic light emitting layer and both the source electrode and the drain electrode, and the auxiliary organic layer can also keep the organic light emitting layer 1032 far away from the source electrode and the drain electrode, which effectively reduces quenching of excitons and exciton-carrier caused by electrodes formed by metal materials such as the source electrode and the drain electrode, and further improves the light emitting efficiency of the device. In a case that the organic light emitting transistor 100 is in operation, a large number of holes are injected into the auxiliary organic layer 1033, and a large number of electrons are injected into the two-dimensional semiconductor material layer 1031. The electrons and the holes move in opposite directions under the voltage applied to the source electrode and the voltage applied to the drain electrode, and the electrons meet the holes in the organic light emitting layer 1032 which is between the auxiliary organic layer 1033 and the two-dimensional semiconductor material layer 1031 to form excitons which transition to realize radio luminescence.

For example, a material of the auxiliary organic layer 1033 includes a material with a hole transport function such as 3,3'''-dihexyl-2,2':5',2":5",2'''-tetrathiophene (DH4T), pentacene, rubrene, 9,10-di-(2-naphthyl)anthracene (ADN), 4,4',4"-tris(carbazol-9-yl)-triphenylamine (TCTA), N,N'-bis-(1-naphthalenyl)-N,N'-bis-phenyl-(1,1'-biphenyl)-4,4'-diamine (NPB) or 4,4',4"-tri-(3-methylphenylanilino)triphenylamine (m-MTDATA), and the like.

For example, an order of the above steps S11, S12, S13, and S14 may be appropriately adjusted to obtain the organic light emitting transistors of other structures. For example, the active layer, the organic light emitting layer, the gate insulation layer and the gate electrode are sequentially formed on the substrate, that is, the organic light emitting transistor of a top-gate type as illustrated in FIG. 4 are formed. For example, in at least one embodiment of the present disclosure, a semi-transparent material or a transparent material such as sapphire or quartz may be used as a material of the substrate, and thus an organic light emitting transistor of a bottom light emitting type is formed.

It is obvious that those skilled in the art can make various changes, modifications and combinations to the embodiments of the present disclosure without departing from the spirit and scope of the present disclosure. Thus, the present disclosure is also intended to include such modifications, variations, and combinations of embodiments of the present disclosure if they fall within the scope of the claims of the present disclosure and their equivalents.

What have been described above are only specific implementations of the present disclosure, the protection scope of the present disclosure is not limited thereto. The protection scope of the present disclosure should be based on the protection scope of the claims.

## Claims

1. An organic light emitting transistor, comprising: a gate electrode, a gate insulation layer, an active layer, a source electrode, and a drain electrode,
wherein the active layer comprises a two-dimensional semiconductor material layer and an organic light emitting layer, the two-dimensional semiconductor material layer and the organic light emitting layer are stacked to form a heterojunction, and the heterojunction is a heterotype heterojunction.

2. The organic light emitting transistor according to claim 1, wherein the heterojunction is a Van der Waals heterojunction.

3. The organic light emitting transistor according to claim 1 or 2, wherein the active layer further comprises an auxiliary organic layer,
wherein the auxiliary organic layer is at a side of the organic light emitting layer away from the two-dimensional semiconductor material layer.

4. The organic light emitting transistor according to claim 3, wherein the auxiliary organic layer is a hole transport layer, and the two-dimensional semiconductor material layer is an electron transport layer.

5. The organic light emitting transistor according to any one of claims 1 to 4, wherein a material of the two-dimensional semiconductor material layer comprises molybdenum sulfide, tungsten sulfide, or boron nitride.

6. The organic light emitting transistor according to any one of claims 1 to 5, wherein the gate electrode is a conductive silicon substrate, and the gate insulation layer and the active layer are sequentially formed on the conductive silicon substrate.

7. The organic light emitting transistor according to claim 6, further comprising an auxiliary electrode layer, wherein the auxiliary electrode layer is at a side of the conductive silicon substrate away from the gate insulation layer, and the auxiliary electrode layer is in an ohmic contact with the conductive silicon substrate.

8. The organic light emitting transistor according to claim 5, wherein the source electrode/ the drain electrode is between the gate insulation layer and the active layer, or, the active layer is between the source electrode/ the drain electrode and the gate insulation layer.

9. The organic light emitting transistor according to any one of claims 1 to 4, further comprising a base substrate, wherein the organic light emitting transistor is a top-gate structure, and the active layer is between the gate electrode and the base substrate.

10. The organic light emitting transistor according to claim 9, wherein the source electrode/ the drain electrode is between the gate insulation layer and the active layer, or the active layer is between the source electrode/ the drain electrode and the gate insulation layer, or, the source electrode/ the drain electrode is on a same layer as the gate electrode.

11. A display panel, comprising a plurality of pixel units arranged in an array, wherein each of the pixel units comprises the organic light emitting transistor according to any one of claims 1 to 10.

12. An electronic device, comprising the organic light emitting transistor according to any one of claims 1 to 10 or the display panel according to claim 11.

13. A manufacturing method of an organic light emitting transistor, comprising:
forming a gate electrode, a gate insulation layer, an active layer, a source electrode, and a drain electrode,
wherein forming the active layer comprises: forming a two-dimensional semiconductor material layer and an organic light emitting layer, the two-dimensional semiconductor material layer and the organic light emitting layer are stacked to form a heterojunction, and the heterojunction is a heterotype heterojunction.

14. The manufacturing method according to claim 13, wherein after forming the two-dimensional semiconductor material layer, an organic light emitting layer material is formed on the two-dimensional semiconductor material layer, and the organic light emitting layer material epitaxially grows along a crystalline phase of the two-dimensional semiconductor material layer to form the organic light emitting layer.

15. The manufacturing method according to claim 13 or 14, wherein a material of the two-dimensional semiconductor material layer comprises molybdenum sulfide, tungsten sulfide, or boron nitride.

16. The manufacturing method according to any one of claims 13 to 15, wherein forming the gate electrode comprises:
providing a silicon substrate;
performing a conducting treatment on the silicon substrate to form a conductive silicon substrate so that the conductive silicon substrate acts as the gate electrode, wherein the gate insulation layer and the active layer are sequentially formed on the conductive silicon substrate.

17. The manufacturing method according to claim 16, wherein an auxiliary electrode layer is formed at a side of the conductive silicon substrate away from the gate insulation layer, and the auxiliary electrode layer is in an ohmic contact with the conductive silicon substrate.

18. The manufacturing method according to any one of claims 13 to 15, further comprising:
providing a base substrate, and forming the active layer, the gate insulation layer and the gate electrode on the base substrate sequentially.

19. The manufacturing method according to claim 13, wherein after forming the organic light emitting layer, the two-dimensional semiconductor material layer is formed on the organic light emitting layer by a transfer printing method.

20. The manufacturing method according to any one of claims 13 to 19, wherein forming the active layer further comprises: forming an auxiliary organic layer at a side of the organic light emitting layer away from the two-dimensional semiconductor material layer.
